Europäisches Patentamt

European Patent Office

Office européen des brevets

(19)

(11) Numéro de publication : **0 038 790**
**B1**

(12) FASCICULE DE BREVET EUROPÉEN

(45) Date de publication du fascicule du brevet :
07.08.85

(51) Int. Cl.⁴ : **G 01 R 31/06, G 01 R 31/34**

(21) Numéro de dépôt : 81870015.5

(22) Date de dépôt : 02.03.81

(54) **Méthode et appareil de détection d'une tenue diélectrique insuffisante de l'isolation de bobinages.**

(30) Priorité : 21.04.80 EP 80200362

(43) Date de publication de la demande :
28.10.81 Bulletin 81/43

(45) Mention de la délivrance du brevet :
07.08.85 Bulletin 85/32

(84) Etats contractants désignés :
AT BE CH DE FR GB IT LI LU NL SE

(56) Documents cités :
US-A- 3 967 196
ELEKTRIE, vol. 25, no. 12, décembre 1971 Berlin, DD
P.R. DUDKOVIC: "Prophylaktische Kontrollmessungen an Isolierungssystemen elektrischer Maschinen" pages 473-475
ASEA JOURNAL, vol. 40, no. 9, 1967 Vasteraas, SE T. ORBECK: "The Measurement of partial discharges in high-voltage coils with a capacitance bridge", pages 125-128
IEEE TRANSACTIONS ELECTRICAL INSULATION, vol. EI-13, no. 1, Février 1978 New York, US, A. KELEN : " Critical Examination of the Dissipation Factor Tip-Up as a Measure of Partial Discharge Intensity", pages 14-24
etz-a, Vol. 97 (1976) No. 11, p. 657-663
Elektrotechnik und Maschinenbau Jg. 95 (1978) No. 12, p. 561-564

(73) Titulaire : ATELIERS DE CONSTRUCTIONS ELECTRIQUES DE CHARLEROI (ACEC) Société Anonyme
Avenue Lloyd George 7
B-1050 Bruxelles (BE)

(72) Inventeur : Goffaux, Raoul Alfred Alexandre F.
Avenue Paul Pastur, 418
B-6100 Mont-sur-Marchienne (BE)

(74) Mandataire : Bossard, Franz et al
ACEC - Service des Brevets Boîte Postale 4
B-6000 Charleroi (BE)

## Description

Le problème d'apprécier la qualité de l'isolation de bobinages de machines électriques à haute tension est posé depuis longtemps. Cependant, comme les raisons d'une détérioration de l'isolation de bobinages ne sont pas tributaires d'une seule cause, on s'est longtemps borné à un empirisme dont les défaillances coûtaient cher d'une part au constructeur parce qu'il devait rebobiner une machine en parfait état et d'autre part à l'exploitant parce que la méthode utilisée ne permettait pas de prévoir un percement imminent de l'isolation de la machine.

Grâce à l'affinement des connaissances, on a récemment reconnu que la tenue diélectrique insuffisante de l'isolation de bobinages apparemment saines était due à l'établissement de décharges partielles localisées à l'intérieur de l'isolation qui apparaissent au-delà d'un certain seuil de tension. Toutefois, cette connaissance ne faisait que déplacer le problème, car les décharges partielles localisées à l'intérieur de l'isolation échappent à une mesure directe.

Selon un point de vue classique, généralement admis, des décharges partielles localisées à l'intérieur de l'isolation ont lieu à l'endroit d'occlusions gazeuses disséminées un peu partout dans l'isolation à haute tension. Lorsqu'à partir d'une certaine tension des décharges partielles s'établissent à l'intérieur d'un nombre de plus en plus important de vacuoles, au fur et à mesure que la tension augmente, la capacité des bobinages varie en fonction de la tension appliquée, car l'intérieur des vacuoles qui sont le siège de décharges devient conducteur. Fort de cette constatation, par exemple TERASE (Elect. Eng. Jap. Février 1973) a proposé un critère de qualité fondé sur l'allure de la courbe de la capacité du bobinage en fonction de la tension appliquée. Cette caractéristique peut être relevée à l'aide d'un pont de mesure de capacités, par exemple d'un pont de Schering.

D'autres méthodes de mesures de décharges partielles utilisant un pont de Schering sont décrits par exemple dans les deux documents suivants.

Dans IEEE Trans. Electr. Insul., vol. EI-13, n° 1 février 1978 pp 14 à 24, on décrit une méthode d'apprécier des mesures de la capacité et du facteur de pertes tg δ fournis par un pont de Schering dans lequel le détecteur d'équilibrage peut être sensible aussi à certaines harmoniques supérieures de la tension appliquée.

Dans ASEA-Journal 1967, Vol. 40, n° 9 pp 125 à 128, un oscillographe est disposé comme détecteur dans la diagonale d'équilibrage du pont. L'oscillographe est branché de manière à mesurer les pertes d'énergie dues à des décharges internes de l'isolation pendant chaque période de la tension de mesure. Ces pertes totalisées sur une période apparaissent sous forme de l'aire d'un parallélogramme visible sur l'oscillographe.

Des méthodes de mesure de décharges partielles internes suivant les recommandations de la publication IEC 270 (1968) n'utilisent pas un pont de mesure de capacités. De telles méthodes sont décrites, par exemple dans les deux documents suivants : ETZ-A Bd 97 (1976) H.11, pp 657 à 663 et Elecktrotechnik und Maschinenbau, Ig 95 (1978, 12) pp 561 à 564. Ces méthodes ont pour but de mesurer la charge totale déplacée dans l'isolation suite à des décharges partielles internes. L'appareillage nécessaire à ces mesures peut comprendre notamment un appareil de mesure sélectif à une certaine fréquence, éventuellement associé à un compteur.

Ces méthodes connues permettent dans certains cas de tirer des conclusions valables. Dans beaucoup d'autres cependant la précision avec laquelle les caractéristiques essentielles d'interprétation peuvent être déterminées est insuffisante. Dans encore d'autres cas, les effets recherchés sont masqués totalement par d'autres phénomènes.

L'invention a pour but une méthode de détection extrêmement sensible, réalisable à l'aide d'appareils de mesure existants et qui fournit des critères d'appréciation significatifs au plan physique se fondant sur la détection de composants nocifs des décharges partielles.

La méthode suivant l'invention se distingue des méthodes connues par le fait qu'elle ne mesure pas les charges totales ou les pertes d'énergie cumulées dues à des décharges internes, mais qu'elle permet de sélectionner pour la mesure les composants nocifs de ces décharges.

L'invention concerne une méthode de détection d'une tenue diélectrique insuffisante et un appareil adapté à l'exécution de cette méthode définis dans les revendications 1 et 2 en annexe.

L'invention est décrite ci-dessous par rapport à un exemple d'exécution représenté dans les figures du dessin annexé.

Les figures 1 et 2 de ce dessin représentent des schémas électriques de ponts de mesure.

La figure 3 montre la forme d'une impulsion moyenne de décharge partielle.

La figure 4 représente des diagrammes mesurés au moyen de l'appareil suivant l'invention.

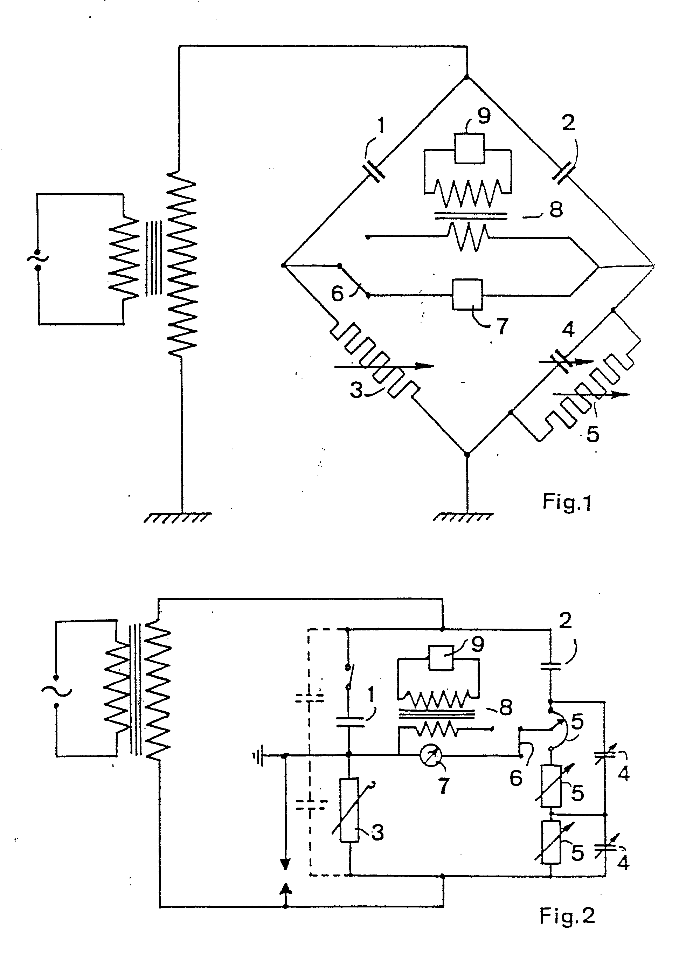

A la figure 1, un pont de mesure est composé de quatre branches et d'une diagonale d'équilibrage. Les quatre branches comprennent une capacité à mesurer 1, constituée en l'occurrence de la capacité d'un enroulement statorique d'un moteur par rapport à la masse de celui-ci, un condensateur de référence 2, une résistance d'équilibrage 3 et un condensateur d'équilibrage 4, mis en parallèle avec une résistance variable 5. Dans la diagonale de mesure est disposé un commutateur 6, relié soit à un appareil indicateur d'équilibre 7, soit à un transformateur à haute fréquence 8, saturable, à noyau en ferrite dont l'enroulement secondaire alimente un voltmètre de crête 9. En lieu et place du commutateur 6, il est possible aussi de relier en permanence le transformateur 8 dans la diagonale de mesure et de placer un filtre passe-bas en série avec l'appareil d'équilibre 7. L'ensemble transformateur 8 et voltmètre 9 peut être remplacé par tout autre dispositif de mesure à haute sélectivité de l'amplitude la plus grande d'impulsions de courant dues aux décharges partielles. Les impulsions de courant mesurées par l'ensemble transformateur 8 et voltmètre 9 dont l'amplitude est la plus grande sont les impulsions nocives.

La mesure est effectuée comme suit : on équilibre le pont à l'aide de l'appareil 7 à la fréquence de 50 Hz d'abord pour chaque tension de mesure d'une gamme autour de la tension nominale du moteur. On mesure de ce fait la capacité de l'enroulement statorique par rapport à la masse du moteur. Dans les conditions d'alimentation du pont représentées à la figure 1, la masse statorique du moteur doit être isolée du sol. S'il s'agit de mesurer la capacité de l'enroulement statorique d'une machine mise à la terre il faudrait soit alimenter le pont par les branches de mesure, soit utiliser un autre schéma de pont p. ex. selon la figure 2.

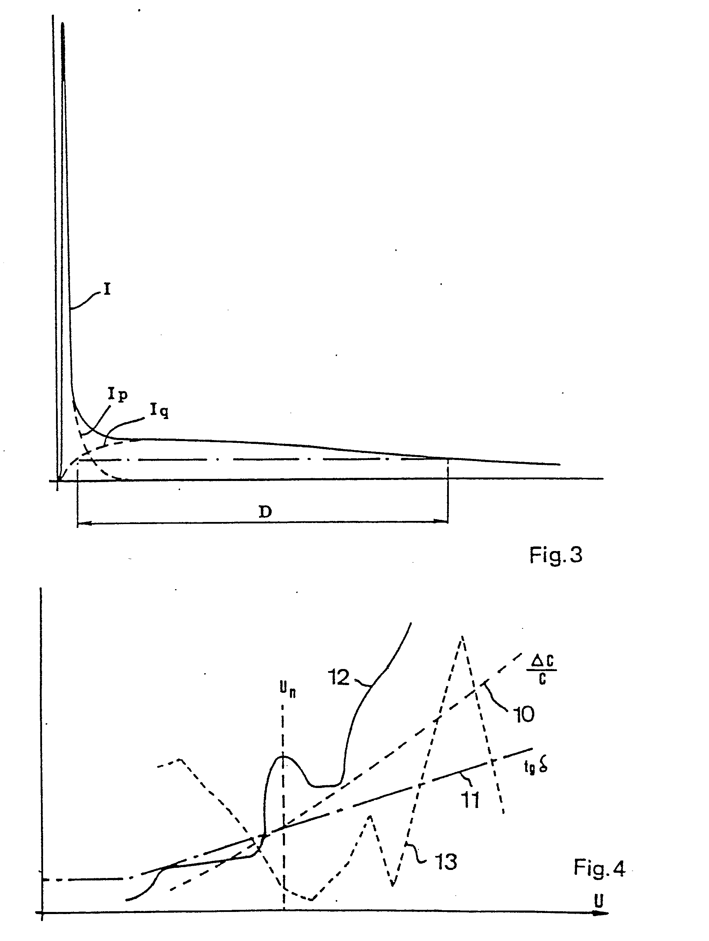

Lorsque l'équilibre du pont est établi, la position du contact mobile du commutateur 6 est changé pour mettre hors circuit l'appareil 7 et pour brancher dans la diagonale de mesure le transformateur 8. Le transformateur 8 est un transformateur à haute sélectivité pour une fréquence f correspondant approximativement à l'inverse de la durée 2D, D étant la durée de la queue d'une impulsion moyenne I des décharges partielles locales. A la figure 3, l'impulsion I est décomposée en deux composants $I_p$ responsable de la pointe et $I_q$ responsable de la queue. Comme on le voit, la composante $I_q$ bien que d'une amplitude faible est de durée très longue et contribue donc davantage à des effets destructifs de l'isolation que la composante $I_p$ de durée extrêmement courte. La durée D de la queue est la durée de l'impulsion $I_q$ à mi-hauteur de l'intensité de crête de cette composante $I_q$. La bande passante de l'ensemble du transformateur 8 et voltmètre de crête 9 est de préférence très étroite autour de la fréquence f = 1/2D. Elle est sélectionnée pour qu'il soit possible d'éliminer la composante $I_p$ ainsi que des impulsions parasites de toute sorte.

Lorsque, par le choix d'un transformateur 8, on a opté pour une fréquence f déterminée, l'appareillage de mesure est sensible à des impulsions moyennes de durée D, si la durée 2D correspond à l'inverse de la fréquence f. Or, la forme de l'impulsion moyenne des décharges partielles locales peut varier en fonction de la tension appliquée et peut varier en outre d'une isolation à l'autre, la variation en fonction de la tension étant la plus importante parmi celles rencontrées. Pour mesurer à l'aise ces décharges partielles, le produit de la capacité du condensateur de référence fois la valeur de résistance de la résistance d'équilibrage doit être égal à un temps plus court que la durée D de l'impulsion moyenne. Il est possible ainsi d'éliminer des mesures l'influence des fronts raides des impulsions. Ces fronts raides ou ces composantes $I_p$ représentent l'énergie nécessaire à la production des charges à l'intérieur de l'isolation, ce qui n'est pas, en soi nocif. Ce qui est nocif, c'est la dynamique d'évacuation ou d'élimination de ces charges représentée par la composante $I_q$. La haute sélectivité de l'ensemble voltmètre de crête 9 et transformateur 8 permet de déterminer la valeur de la tension de mesure pour laquelle l'impulsion de décharge moyenne présente une durée D, car à cette valeur de tension, la courbe qui représente les valeurs mesurées par le voltmètre de crête 9 en fonction des tensions de mesure présente un maximum relatif. Si, au contraire, la courbe mesurée ne présente pas de maximum accusé, il faut en conclure que d'autres phénomènes liés aux décharges partielles locales à l'endroit de vacuoles se manifestent qui n'entraînent pas de dégradation de l'isolation. Cette dernière peut donc être considérée comme saine.

Le transformateur 8 est un transformateur saturable, la saturation entrant en jeu dès que la quantité de charges traversant le primaire du transformateur dépasse un seuil situé au-dessus d'une valeur compatible avec le phénomène des décharges partielles locales. Si ce seuil est dépassé, le phénomène enregistré n'a donc plus rien de commun avec des décharges partielles locales (exemple : décharges superficielles).

Il est possible aussi de remplacer le voltmètre de crête 9 par un compteur d'impulsions nocives. La nocivité d'une impulsion peut être appréciée d'une part par son intensité et d'autre part par sa fréquence d'apparition. Si une telle impulsion se manifeste à chaque alternance de la fréquence de la tension alternative de mesure, il s'agit d'un phénomène permanent qui à plus ou moins brève échéance doit détruire l'isolation. Par contre, si par exemple la fréquence d'apparition d'impulsions nocives est en dessous d'un taux de 0,5 par alternance de la fréquence de la tension alternative de mesure, l'apparition de telles impulsions peut être considérée comme erratique, ne conduisant pas à une destruction de l'isolation à brève échéance.

Dans le but d'effectuer ce comptage, le compteur d'impulsions nocives comprend un étage d'entrée à seuil, de préférence réglable, à travers lequel passent uniquement les impulsions d'une intensité au-dessus du seuil réglé. D'autre part, la période d'échantillonnage de ce compteur est choisie de préférence entre 50 à 1 000 alternances de la fréquence de la tension de mesure. Il est recommandé de rester en dessous de 1 000 alternances pour ne pas allonger inutilement le temps de mesure. Le minimum de 50 alternances devrait être respecté dans le but de réduire l'influence du bruit qui provient d'impulsions parasites engendrés dans le réseau, par exemple lors de l'enclenchement et du déclenchement de disjoncteurs.

Le procédé de mesure peut consister dans le choix d'une intensité de seuil unique pour toute la gamme de mesure ou d'une série de plusieurs réglages de seuil différents pour chaque tension de mesure ou encore d'une intensité de seuil unique pour chaque tension de mesure, choisie en fonction de la tension de mesure, par exemple proportionnelle à la tension de mesure.

Une méthode de mesure particulièrement avantageuse résulte d'une combinaison des mesures faites d'une part par le voltmètre de crête et d'autre part du compteur d'impulsions. Dans ce cas, un compteur d'impulsions à étage d'entrée à seuil est branché en parallèle sur le voltmètre de crête 9. Le seuil du compteur d'impulsions est réglé, soit à la main, soit automatiquement égale à une tension légèrement inférieure à l'amplitude de l'impulsion la plus grande appliquée au voltmètre de crête, par exemple à une valeur mesurant entre 98 % et 80 % de cette amplitude. La comparaison des mesures enregistrées par le voltmètre de crête d'une part et par le compteur d'impulsions d'autre part permet d'interpréter avec une autorité plus grande les phénomènes susceptibles de causer une destruction de l'isolation des bobinages des machines testées.

Les avantages du procédé de mesure décrit ci-dessus ne s'épuisent pas par la détection des décharges internes. Mais cette détection des décharges internes est facilitée même en présence de décharges d'autres natures comme les décharges superficielles ou décharges d'encoches à cause de la sélectivité du procédé de mesure selon l'invention pour les décharges internes. A partir d'un certain niveau de la tension de mesure cependant, les décharges superficielles et/ou d'encoches masquent la détection des décharges internes. Ceci n'est pas gênant dans les cas pratiques où il importe seulement de déterminer si une isolation est bonne ou non. En effet une isolation en bon état ne peut pas présenter des décharges superficielles ou des décharges d'encoches en dessous de la tension de service et même immédiatement au-dessus de celle-ci.

Il est d'ailleurs possible de distinguer si un accroissement des valeurs mesurées par le voltmètre de crête 9 résulte de décharges internes ou de décharges superficielles ou d'encoches. En effet l'accroissement des valeurs mesurées par le voltmètre de crête 9 en fonction de la tension de mesure devient subitement beaucoup plus grand. S'il s'agit de décharges superficielles, l'opérateur sent en même temps l'odeur caractéristique d'ozone et il entend le bruit engendré par ces décharges superficielles. Si l'opérateur s'attarde un peu à chaque mesure, les fréquences d'apparition des décharges superficielles notamment à tension élevée tombe en moins d'une minute de par exemple 1 décharge par alternance à 1 décharge par 50 alternances.

Dans le cas de l'apparition de décharges d'encoches, on n'entend pas de bruit et on ne sent pas l'odeur d'ozone. Grâce à ces manifestations accessoires, il est donc possible d'éclaircir tout un éventail de phénomènes caractéristiques qui peuvent contribuer à l'appréciation de la bonne ou moins bonne tenue diélectrique d'une isolation d'une machine électrique.

La figure 4 montre plusieurs diagrammes superposés de mesures faites par l'installation selon l'invention. Pour toutes les courbes la tension de mesure est portée en abscisse, tandis qu'en ordonnée sont portées les valeurs des différentes grandeurs. Les grandeurs représentées par les différentes courbes sont les suivantes : courbe 10 : accroissement relatif de la capacité du bobinage par rapport à la masse de la machine ; courbe 11 : la $tg\delta$ de l'isolation ; courbe 12 : la valeur mesurée par le voltmètre de crête 9 ; courbe 13 : le nombre de décharges par alternance compté par le compteur d'impulsions nocives. Alors que les courbes 10 et 11 ne présentent aucun accident de l'isolation, il n'en est pas de même des courbes 12 et 13. A des tensions sensiblement en dessous de la tension nominale $U_n$ de la machine électrique mesurée, des décharges internes nombreuses de faible amplitude sont mesurées par le voltmètre de crête et apparaissent presqu'à chaque alternance, mais au fur et à mesure que la tension de mesure augmente des décharges moins nombreuses, mais de plus grande amplitude sont produites et mesurées par le voltmètre de crête et enregistrées par le compteur. Ceci explique l'allure décroissante de la courbe 13. Cependant, l'amplitude maximum des décharges mesurée par le voltmètre de crête 9 passe par un maximum relatif à l'endroit de la tension nominale. Un peu au-dessus de la tension nominale, la courbe 12 présente un coude à partir duquel part une branche croissante due à des décharges superficielles. A partir de la tension de mesure correspondant à ce coude, l'opérateur sent l'odeur caractéristique de l'ozone ; il s'agit donc bien de décharges superficielles. La fréquence d'apparition de ces décharges mesurées par le compteur d'impulsions nocives présente deux maxima qui sont l'indice du fait qu'à partir de certaines tensions élevées certains points faibles donnant lieu à des décharges superficielles sont brûlés et éliminés. Une isolation présentant des courbes selon la figure 4 doit donc être considérée comme relativement bonne puisque les décharges internes les plus nocives n'ont encore qu'un caractère erratique et que des décharges superficielles apparaissent seulement à des tensions de mesure sensiblement plus élevées que la tension nominale de la machine. Cependant, le fait que le maximum de la courbe 12 se situe à l'endroit de la tension nominale indique que cette isolation devra être contrôlée à nouveau à relativement brève échéance.

**Revendications**

1. Méthode de détection d'une tenue diélectrique insuffisante de l'isolation de bobinages d'une machine électrique, méthode selon laquelle
— le condensateur (1) constitué par les conducteurs desdits bobinages, l'isolation et les parties de la masse de la machine disposées autour de ces bobinages est raccordé dans la branche de mesure d'un pont de mesure de capacité,

— le pont de mesure est alimenté en une tension alternative de mesure dont la valeur est prise dans une gamme de valeurs prédéterminées autour de la tension nominale de la machine et dont la fréquence est choisie parmi les fréquences apparaissant aux bobinages dans les conditions de service de la machine,

— l'équilibre du pont de mesure est établi à l'aide d'un indicateur d'équilibre (7) branché dans la diagonale de mesure du pont de mesure pour la valeur de la tension de mesure appliquée au pont de mesure, caractérisée en ce que les impulsions de courant moyennes dues à des décharges partielles dans l'isolation et présentant une première partie constituée par une pointe ($I_p$) de front raide et une seconde partie constituée par une queue ($I_q$) décroissante sont détectées pour chacune des valeurs prédéterminées de la tension de mesure par l'intermédiaire d'un dispositif de mesure (8, 9) à haute sélectivité accordé à une fréquence correspondant à l'inverse de la durée 2D, D étant la durée de la queue ($I_q$) d'une desdites impulsions de courant moyennes prédéterminées, le dispositif de mesure (8, 9) étant disposé en lieu et place de l'indicateur d'équilibre après l'établissement de l'équilibre du pont de mesure pour la tension de mesure appliquée.

2. Appareil pour détecter une tenue diélectrique insuffisante de l'isolation des bobinages d'une machine électrique selon la méthode de la revendication 1, comportant :

— un pont de mesure de capacité à résistances (3, 5) et condensateurs (1, 2, 4), une des branches de ce pont étant destinée à recevoir le condensateur (1) constitué par les conducteurs des bobinages, l'isolation à inspecter et les parties de la masse de la machine disposées autour de ces bobinages, ledit pont comportant des éléments d'équilibrage (3, 4).

— une source d'alimentation du pont de mesure par une tension de mesure alternative ajustable à l'une des valeurs d'une gamme de valeurs prédéterminées autour de la tension nominale de la machine, la fréquence de la tension de mesure étant choisie parmi les fréquences apparaissant aux bobinages dans les conditions de service de la machine,

— un indicateur d'équilibre (7) pour indiquer l'établissement de l'équilibre du pont de mesure, l'appareil étant caractérisé en ce qu'il comporte en outre :

— un dispositif de mesure (8, 9) à haute sélectivité de fréquence pour détecter les impulsions de courant moyennes dues à des décharges partielles dans l'isolation et présentant une première partie constituée par une pointe ($I_p$) de front raide et une seconde partie constituée par une queue ($I_q$) décroissante, ledit dispositif de mesure étant accordé à une fréquence correspondant à l'inverse de la durée 2D, D étant la durée de la queue d'une desdites impulsions de courant moyennes prédéterminée,

— un dispositif sélecteur (6) permettant de brancher soit l'indicateur d'équilibre (7) soit le dispositif de mesure (8, 9) dans la diagonale de mesure du pont de mesure.

3. Appareil suivant la revendication 2, caractérisé en ce que le dispositif de mesure comprend un transformateur (8) hautement sélectif pour ladite fréquence correspondant à l'inverse de la durée 2D, D étant la durée de ladite queue.

4. Appareil suivant la revendication 3, caractérisé en ce que le transformateur (8) hautement sélectif est un transformateur saturable.

5. Appareil suivant une des revendications 3 à 4, caractérisé en ce que le dispositif de mesure est un voltmètre de crête (9) branché sur le secondaire du transformateur (8).

6. Appareil suivant une des revendications 3 à 4, caractérisé en ce que le dispositif de mesure est un compteur branché sur le secondaire du transformateur (8) et comprenant une période d'échantillonnage prédéterminée, et un étage d'entrée laissant passer les impulsions au-dessus d'une amplitude de seuil.

7. Appareil suivant la revendication 6, caractérisé en ce que la période d'échantillonnage est choisie entre 50 et 1 000 alternances de la fréquence de la tension de mesure.

8. Appareil suivant la revendication 3 ou 4, caractérisé en ce que le dispositif de mesure est constitué par une mise en parallèle d'un voltmètre de crête et d'un compteur comportant un étage d'entrée laissant passer les impulsions au-dessus d'une amplitude de seuil, le voltmètre et le compteur étant branchés sur le secondaire du transformateur.

9. Appareil suivant la revendication 8, caractérisé en ce qu'il comprend un dispositif de réglage du seuil à l'entrée du compteur actionné de la valeur mesurée dans le voltmètre de crête.

**Claims**

1. Method for the detection of insufficient dielectric properties of the insulation of coil windings of an electrical machine, according to which method

— the capacitor (1) constituted by the conductors of the said windings, the insulation, and the portions of the mass of the machine which are situated around these windings, is connected into the measuring branch of a capacitance measuring bridge,

— the measuring bridge is supplied with a measurement A.C. voltage whose value is taken from a range of predetermined values around the nominal voltage of the machine and whose frequency is selected from the frequencies appearing at the windings in the operating conditions of the machine,

— the equilibrium of the measuring bridge is established by means of an equilibrium indicator (7) connected into the measuring diagonal of the measuring bridge for the value of the measurement voltage applied to the measuring bridge, characterised in that the mean current pulses due to partial discharges in the insulation and having a first portion constituted by a steep front peak ($I_p$) and a second portion constituted by a decreasing tail ($I_q$) are detected for each of the predetermined values of the measurement voltage by :neans of a measuring device (8, 9) of high selectivity tuned to a frequency corresponding to the inverse of the duration 2D, D being the duration of the tail ($I_q$) of one of the said predetermined mean current pulses, the measuring device (8, 9) being arranged in the place of the equilibrium indicator after the establishment of the equilibrium of the measuring bridge for the applied measurement voltage.

2. Apparatus for the detection of insufficient dielectric properties of the insulation of coil windings of an electrical machine according to the method of claim 1, comprising :

— a capacitance measuring bridge with resistors (3, 5) and capacitors (1, 2, 4), one of the branches of this bridge being intended to receive the capacitor (1) constituted by the conductors of the windings, the insulation being checked, and the portions of the mass of the machine situated about these windings, the said bridge comprising balancing elements (3, 4),

— a source for supplying the measuring bridge with an A.C. measurement voltage adjustable to one of the values of a range of predetermined values around the nominal voltage of the machine, the frequency of the measurement voltage being chosen from the frequencies appearing at the windings in the operating conditions of the machine,

— an equilibrium indicator (7) for indicating the establishment of equilibrium in the measuring bridge,

the apparatus being characterised in that it also comprises :

— a measuring device (8, 9) with high frequency selectivity for detecting the mean current pulses due to partial discharges in the insulation and having a first portion constituted by a steep front peak ($I_p$) and a second portion constituted by a decreasing tail ($I_q$), the said measuring device being tuned to a frequency corresponding to the inverse of the duration 2D, D being the duration of the tail of one of the said predetermined mean current pulses,

— a selector device (6) allowing either the equilibrium indicator (7) or the measuring device (8, 9) to be connected into the measuring diagonal of the measuring bridge.

3. Apparatus according to claim 2, characterised in that the measuring device comprises a transformer (8) highly selective for the said frequency corresponding to the inverse of the duration 2D, D being the duration of the said tail.

4. Apparatus according to claim 3, characterised in that the highly selective transformer (8) is a saturatable transformer.

5. Apparatus according to one of claims 3 and 4, characterised in that the measuring apparatus is a peak voltmeter (9) connected to the secondary of the transformer (8).

6. Apparatus according to one of claims 3 and 4, characterised in that the measuring device is a counter connected to the secondary of the transformer (8) and comprising a predetermined sampling period, and an input stage allowing the passage of the pulses above a threshold amplitude.

7. Apparatus according to claim 6, characterised in that the sampling period is chosen between 50 and 1 000 alternations of the frequency of the measuring voltage.

8. Apparatus according to claim 3 or 4, characterised in that the measuring device is constituted by an in-parallel arrangement of a peak voltmeter and a counter comprising an input stage allowing the passage of the pulses above a threshold amplitude, the voltmeter and the counter being connected to the secondary of the transformer.

9. Apparatus according to claim 8, characterised in that it comprises a regulating device for the threshold at the input of the counter actuated with the value measured in the peak voltmeter.

## Patentansprüche

1. Verfahren zur Feststellung unzureichender dielektrischer Eigenschaften der Isolation einer Spulenwicklung einer elektrischen Maschine, bei dem

— der Kondensator (1), der von den Leitern der besagten Spulenwicklungen, der Isolation und den um diese Spulenwicklungen angeordneten Teilen der Masse der Maschine gebildet wird, in den Meßzweig einer Kapazitäts-Meßbrücke geschaltet ist,

— die Meßbrücke durch eine Meß-Wechselspannung versorgt wird, deren Wert innerhalb einer Reihe von vorgegebenen Werten um die Nennspannung der Maschine herum ausgewählt wird, und deren Frequenz unter den Frequenzen ausgewählt wird, die an den Spulenwicklungen unter den Betriebsbedingungen der Maschine auftreten,

— das Gleichgewicht der Meßbrücke mit Hilfe einer in die Meßdiagonale der Meßbrücke geschalteten Gleichgewichtsanzeige (7) für den an die Meßbrücke angelegten Wert der Meßspannung hergestellt wird, dadurch gekennzeichnet, daß die auf partielle Entladungen in der Isolation zurückzuführenden mittleren Stromimpulse, die einen aus einer Spitze mit steiler Front bestehenden ersten Teil ($I_p$), und einen aus einem abfallenden Schwanz bestehenden zweiten Teil ($I_q$) aufweisen, für jeden der vorgegebenen Werte der Meßspannung mittels einer Meßvorrichtung (8, 9) nachgewiesen werden, die eine hohe Selektivität aufweist, und die auf eine Frequenz abgestimmt ist, die dem Reziprokwert der Dauer 2D entspricht, wenn D die vorgegebene Dauer des Schwanzes ($I_q$) von einem der besagten mittleren Stromimpulse ist, wobei die Meßvorrichtung (8, 9) nach Herstellung des Gleichgewichts der Meßbrücke für die angelegte Meßspannung anstelle der Gleichgewichtsanzeige ángeordnet wird.

2. Vorrichtung zur Feststellung unzureichender dielektrischer Eigenschaften der Isolation einer Spulenwicklung einer elektrischen Maschine gemäß dem Verfahren von Anspruch 1, aus :

— einer Kapazitäts-Meßbrücke mit Widerständen (3, 5) und Kondensatoren (1, 2, 4), wobei einer der Zweige dieser Brücke für die Aufnahme des Kondensators (1) bestimmt ist, der von den Leitern der Spulenwicklungen, der zu prüfenden Isolation und den um diese Spulenwicklungen angeordneten Teilen der Masse der Maschine gebildet wird, und wobei die besagte Brücke Abgleichelemente (3, 4) aufweist,

— einer Quelle für die Versorgung der Meßbrücke mit einer Meß-Wechselspannung, die auf einen der Werte einer Reihe von Werten um die Nennspannung der Maschine herum einstellbar ist, wobei die Frequenz der Meßspannung unter den Frequenzen ausgewählt wird, die unter den normalen Betriebsbedingungen der Maschine an den Spulenwicklungen

— einer Gleichgewichtsanzeige (7) zur Anzeige des Gleichgewichts der Meßbrücke, dadurch gekennzeichnet, daß die Vorrichtung außerdem folgende Einrichtungen aufweist :

— eine Meßvorrichtung (8, 9) mit hoher Frequenz-Selektivität zum Nachweis der auf partielle Entladungen in der Isolation zurückzuführenden mittleren Stromimpulse, die einen aus einer Spitze mit steiler Front bestehenden ersten Teil ($I_p$), und einen aus einem abfallenden Schwanz bestehenden zweiten Teil ($I_q$) aufweisen, wobei die besagte Meßvorrichtung auf eine Frequenz abgestimmt ist, die dem Reziprokwert der Dauer 2D entspricht, wenn D die vorgegebene Dauer des Schwanzes von einem der besagten mittleren Stromimpulse ist,

— eine Wählvorrichtung (6), die gestattet, entweder die Gleichgewichtsanzeige (7), oder die Meßvorrichtung (8, 9) in die Meßdiagonale der Meßbrücke zu schalten.

3. Vorrichtung gemäß Anspruch 2, dadurch gekennzeichnet, daß die Meßvorrichtung einen Transformator (8) aufweist, der eine hohe Selektivität gegenüber der besagten Frequenz aufweist, die dem Reziprokwert der Dauer 2D entspricht, wobei D die Dauer des besagten Schwanzes ist.

4. Vorrichtung gemäß Anspruch 3, dadurch gekennzeichnet, daß der hochselektive Transformator (8) ein sättigbarer Transformator ist.

5. Vorrichtung gemäß einem der Ansprüche 3 oder 4, dadurch gekennzeichnet, daß die Meßvorrichtung ein Spitzenspannungs-Voltmeter (9) ist, das an die Sekundärwicklung des Transformators (8) angeschlossen ist.

6. Vorrichtung gemäß einem der Ansprüche 3 oder 4, dadurch gekennzeichnet, daß die Meßvorrichtung ein Zähler ist, der an die Sekundärwicklung des Transformators (8) angeschlossen ist und eine vorgegebene Sampling-Periode aufweist und mit einer Eingangsstufe versehen ist, die die Impulse hindurchläßt, die oberhalb einer Schwellenamplitude liegen.

7. Vorrichtung gemäß Anspruch 6, dadurch gekennzeichnet, daß die Sampling-Periode zwischen 50 und 1 000 Halbwellen der Meß-Wechselspannung gewählt wird.

8. Vorrichtung gemäß Anspruch 3 oder 4, dadurch gekennzeichnet, daß die Meßvorrichtung aus einer Parallelschaltung eines Spitzenspannungs-Voltmeters und eines Zählers besteht, wobei der Zähler eine Eingangsstufe aufweist, die nur die Impulse hindurchläßt, die oberhalb einer Schwellenamplitude liegen, und daß das Voltmeter und der Zähler an die Sekundärwicklung des Transformators angeschlossen sind.

9. Vorrichtung gemäß Anspruch 8, dadurch gekennzeichnet, daß sie eine Vorrichtung zur Einstellung der Schwelle für den von dem Spitzenspannungs-Voltmeter gemessenen Wert am Eingang des betätigten Zählers aufweist.

0 038 790

Fig.1

Fig.2

1

Fig.3

Fig.4